# EUROPÄISCHE PATENTSCHRIFT

(11) **EP 2 414 913 B1**
(45) Veröffentlichungstag und Bekanntmachung des Hinweises auf die Patenterteilung: **12.11.2014**
(21) Anmeldenummer: 10717042.5
(22) Anmeldetag: 30.03.2010
(51) Int. Cl.: G06F 3/01

(54) **VORRICHTUNG ZUR ERZEUGUNG EINER HAPTISCHEN RÜCKMELDUNG EINER TASTENLOSEN EINGABEEINHEIT**
DEVICE FOR CREATING A HAPTIC FEEDBACK OF A KEYLESS INPUT UNIT
DISPOSITIF DE PRODUCTION D'UN MESSAGE DE RÉPONSE HAPTIQUE SUR UNE UNITÉ D'ENTRÉE SANS TOUCHES

(30) Priorität: 02.04.2009 DE 102009015991
(43) Veröffentlichungstag der Anmeldung: 08.02.2012
(73) Patentinhaber: Pi Ceramic GmbH, 07589 Lederhose (DE)
(72) Erfinder: HENNIG, Eberhard, 07646 Mörsdorf (DE); DITAS, Peter, 07589 Münchenbernsdorf (DE)
(74) Vertreter: Grünecker, Kinkeldey, Stockmair & Schwanhäusser
(86) Internationale Anmeldenummer: PCT/EP2010/002018
(87) Internationale Veröffentlichungsnummer: WO 2010/112198

(56) Entgegenhaltungen:
- EP-A1- 1 544 720
- EP-A1- 1 566 728
- WO-A1-2008/125130
- DE-T5-112005 002 107
- US-A1- 2004 227 721
- US-A1- 2006 028 095
- US-A1- 2008 100 177
- US-A1- 2008 122 315
- US-A1- 2008 251 364

## Beschreibung

Die Erfindung bezieht sich auf eine Vorrichtung zur Erzeugung einer haptischen Rückmeldung tastenloser Eingabeeinheiten wie "Touchscreens" oder "Keypads" in mobilen IT-Geräten wie Mobiltelefonen, tragbaren portablen Assistenten (Portable Digital Assistant, abgekürzt PDA), Musik- oder Multimediaspielern, Kameras, Navigationsgeräten, usw.

Insbesondere trägt die Erfindung den aktuellen Forderungen des Markts Rechnung, wonach IT-Geräte gefordert werden, bei welchen das Display einer tastenlosen Eingabeeinheit, insbesondere eines Touchscreens, als Ganzes im Wesentlichen senkrecht zur Gehäusefläche in mindestens einer Richtung bewegbar ist.

In der US 7,324,094 B2 ist beispielsweise der Einsatz eines piezoelektrischen Biegeelementes beschrieben, das zur Erzeugung einer haptischen Rückmeldung in Folge eines Bedienschrittes durch den Benutzer ein Vibrationssignal generiert. Hierbei wird das Vibrationssignal durch das piezoelektrische Biegeelement auf eine das Display überdeckende und überragende Linse übertragen. Konkret ist das vibrierende Element an einer Stelle der Linse angeordnet, die außerhalb des Überdeckungsbereichs zwischen Linse und Display liegt.

Auch in der WO 2008/125130 A1 wird der Einsatz eines piezoelektrischen Biegeelementes beschrieben, das sowohl durch eine aktorische Funktion als auch durch eine sensorische Funktion gekennzeichnet ist. Das piezoelektrische Biegeelement ist hierbei in einem Keypad oder Touchpad angeordnet, das mehrere unterschiedliche Funktionen aufweisende Lagen oder Schichten besitzt. Das piezoelektrische Biegeelement stellt eine dieser Lagen oder Schichten dar, wobei es im Wesentlichen die gleiche Größe wie die anderen Lagen oder Schichten aufweist. Bei Registrierung eines Bedienschrittes durch den Benutzer, beispielsweise eines Tastendrucks, erzeugt das piezoelektrische Biegeelement Vibrationen, welche sich auf die über diesem angeordneten Schichten bis an die Oberfläche des Key- oder Touchpads übertragen, was durch den Benutzer als haptische Rückmeldung registrierbar ist.

In beiden zuvor erwähnten Druckschriften konnte kein Hinweis gefunden werden, der auf eine Lösung des obigen Problems, d.h. das Heben des Displays als Ganzes, hinweist. In der DE 11 2005 002 107 T5 wird zwar eine taktile Frontplatte beschrieben, welche die Merkmale einer haptischen Rückmeldung durch einen mechanischen Impuls mit vertikaler Hauptrichtung aufweist. Allerdings wird hier der Impuls durch eine rein mechanische Lösung generiert, d.h. durch eine abrupte Verformung (Einsacken) eines elastisch deformierbaren Elements. In einer speziellen Ausführung wird zwar auch auf einen "piezoelektrischen Fühler" hingewiesen, bei der aber die Frontplatte unbeweglich ist.

In der US 2008/0251364 wird eine Vorrichtung zur Erzeugung einer haptischen Rückmeldung mit einer Eingabeeinheit offenbart, wobei ein Piezoaktuator, eine Isolationsschicht und ein kapazitiver Sensor aufeinanderfolgend geschichtet angeordnet sind. Die Isolationsschicht ist mit einem elastischen, plattenförmigen Substrat vergleichbar.

Aus den vorliegenden Informationen muss davon ausgegangen werden, dass für die oben beschriebene Aufgabenstellung, nämlich das Bewegen des Displays einer tastenlosen Eingabeeinheit als Ganzes im Wesentlichen senkrecht zur Gehäusefläche in mindestens einer Richtung, keine befriedigende Lösung bekannt ist, insbesondere im Hinblick auf eine einfache Montage und der Eignung für eine kostengünstige Massenproduktion.

Um die oben genannte Aufgabe zu lösen, stellt die Erfindung eine Vorrichtung zur Erzeugung einer haptischen Rückmeldung einer tastenlosen Eingabeeinheit bereit, wobei die Vorrichtung ein elastisches, im Wesentlichen plattenförmiges Substrat aufweist, das mindestens eine erste Lagerstelle zur Festlegung des Substrats an einer Struktur des Eingabegeräts und mindestens eine zweite Lagerstelle zur Festlegung des Substrats an der Eingabeeinheit umfasst, und derart ausgebildet ist, um die Eingabeeinheit beweglich gegenüber der Struktur des Eingabegeräts zu lagern, wobei ein piezoelektrisches Element zwischen den ersten und zweiten Lagerstellen des Substrats derart angeordnet ist, dass bei einer elektrischen Ansteuerung des piezoelektrischen Elements eine der Lagerstellen quer zur Ebene des plattenförmigen Substrats, vorzugsweise im Wesentlichen senkrecht zur Ebene des plattenförmigen Substrats aus der Ebene des plattenförmigen Substrats heraus, bewegt wird. Diese Bewegung kann ein haptisches Signal für die Eingabeeinheit derart erzeugen, dass die Eingabeeinheit (z.B. Touchscreen) als Ganzes im Wesentlichen senkrecht zur Struktur des Eingabegeräts (z.B. Gehäusefläche) mindestens in einer Richtung bewegt wird. Die Vorrichtung bildet einen piezoelektrischen Aktuator, der vorzugsweise an den vier Ecken des Displays angekoppelt wird. Ein solcher Aktuator weist eine robuste Bauweise auf und lässt sich kostengünstig fertigen und montieren.

Unter dem Aspekt der Miniaturisierung kann es hilfreich sein, wenn das piezoelektrische Element in das Substrat eingebettet ist. Dadurch kann die Bauhöhe der erfindungsgemäßen Vorrichtung verringert werden.

Um ein haptisches Signal in zwei Richtungen zu erzeugen, kann es nützlich sein, wenn ein piezoelektrisches Element auf einer Oberseite und/oder einer Unterseite des Substrats angebracht ist.

Es kann praktisch sein, wenn mehrere zweite Lagerstellen symmetrisch, vorzugsweise spiegelsymmetrisch zu einer Achse, bevorzugt spiegelsymmetrisch zu zwei Achsen, insbesondere spiegelsymmetrisch zu zwei senkrecht stehenden Achsen, auf dem Substrat angeordnet sind. Dadurch können ungewollte Neigungen und Kippbewegungen der tastenlosen Eingabeeinheit gegenüber einer Gehäusefläche des Eingabegeräts weitgehend verhindert werden.

Es kann vorteilhaft sein, wenn sich die ersten und zweiten Lagerstellen auf ersten und zweiten Lagerabschnitten des Substrats befinden, die über einen Steg verbunden sind. Vorzugsweise ist der Steg des Substrats im Verhältnis wesentlich dünner als die ersten und zweiten Lagerabschnitte des Substrats, so dass sich die ersten und zweiten Lagerabschnitte weitgehend unabhängig voneinander verformen können, insbesondere in einer Richtung quer bzw. senkrecht zur Ebene des plattenförmigen Substrats.

Unter dem Aspekt einer kostengünstigen Fertigung und Montage der erfindungsgemäßen Vorrichtung kann es günstig sein, wenn zumindest einer der Lagerabschnitte, vorzugsweise die ersten und zweiten Lagerabschnitte, aus dem Substrat freigeschnitten ist/sind. Dadurch kann das Substrat im Wesentlichen aus einer rechteckigen oder quadratischen Platte gestanzt werden und die Anzahl der Einzelteile wird verringert.

Es kann sich als vorteilhaft erweisen, wenn sich die Lagerabschnitte jeweils quer, vorzugsweise senkrecht, zum Steg, bevorzugt zu beiden Seiten des Stegs, erstrecken. Dadurch können besonders die freien Enden der über den Steg verbundenen Lagerabschnitte gut zueinander beweglich gestaltet werden, auch wenn sie dicht beieinander liegen.

Es kann sich als praktisch erweisen, wenn eine zweite Lagerstelle an einem freien Ende eines zweiten Lagerabschnitts angeordnet ist. Dadurch kann eine induzierte Biegebewegung des zweiten Lagerabschnitts über die zweite Lagerstelle optimal an die Eingabeeinheit übertragen werden, um ein haptisches Signal zu generieren.

Unter dem Aspekt einer gleichmäßigen Lagerung der Eingabeeinheit kann es vorteilhaft sein, wenn ein erster Lagerabschnitt zwischen zwei zweiten Lagerabschnitten angeordnet ist und/oder umgekehrt.

Zur gleichmäßigen Lagerung der Eingabeeinheit kann es aber auch vorteilhaft sein, wenn mindestens ein erster Lagerabschnitt einen Rahmen bildet, der einen zweiten Lagerabschnitt zumindest über die Hälfte seines Umfangs, vorzugsweise über seinen gesamten Umfang, umgibt und/oder umgekehrt. In dieser Ausführung weist das Substrat ferner auch eine besonders stabile und verwindungssteife Struktur auf.

Es kann hilfreich sein, wenn das piezoelektrische Element in oder auf einem zweiten Lagerabschnitt angeordnet ist. Das in oder auf einem zweiten Lagerabschnitt angeordnete piezoelektrische Element induziert eine Biegung des zweiten Lagerabschnitts, welche über die zweite Lagerstelle optimal auf die anzukoppelnde Eingabeeinheit übertragbar ist.

Es kann nützlich sein, wenn das Substrat einstückig ausgebildet ist. Dadurch wird die Herstellung und Montage der erfindungsgemäßen Vorrichtung vereinfacht.

Es kann sich als vorteilhaft erweisen, wenn das Substrat aus Leiterkartenmaterial, Metall, Kunststoff oder Keramik gefertigt ist. Derartige Materialien weisen die bevorzugten Eigenschaften als Substrat auf, sind in der Regel kostengünstig verfügbar und leicht zu bearbeiten.

Es kann sich als praktisch erweisen, wenn das Substrat aus elektrisch leitfähigem Material gefertigt und/oder mit elektrisch leitfähigem Material beschichtet ist. Bei dieser Ausführung können die piezoelektrischen Elemente einfach und zuverlässig kontaktiert werden.

Ein weiterer bevorzugter Aspekt der Erfindung betrifft ein mobiles Eingabegerät mit einer tastenlosen Eingabeeinheit und einer Vorrichtung zur Erzeugung einer haptischen Rückmeldung der tastenlosen Eingabeeinheit nach einer der vorangegangenen Ausführungen, wobei eine der ersten Lagerstellen des Substrats an einer Struktur des Eingabegeräts festgelegt ist und eine der zweiten Lagerstellen des Substrats an der Eingabeeinheit festgelegt ist.

Die bevorzugten Ausführungsbeispiele und Anwendungen der Erfindung werden nachstehend mit Bezug auf die beiliegenden Zeichnungen im Detail beschrieben. Es zeigen
- Figur 1: Eine perspektivische Ansicht eines Eingabegerätes mit einer tastenlosen Eingabeeinheit.
- Figur 2: Eine schematisch dargestellte Schnittansicht des Eingabegerätes mit einer tastenlosen Eingabeeinheit und der erfindungsgemäßen Vorrichtung zur Erzeugung einer haptischen Rückmeldung der tastenlosen Eingabeeinheit.
- Figur 3: Eine Draufsicht auf eine erfindungsgemäße Vorrichtung zur Erzeugung einer haptischen Rückmeldung der tastenlosen Eingabeeinheit gemäß Variante 1.
- Figur 4: Eine Draufsicht auf eine erfindungsgemäße Vorrichtung zur Erzeugung einer haptischen Rückmeldung der tastenlosen Eingabeeinheit gemäß Variante 2.
- Figur 5: Eine Draufsicht auf eine erfindungsgemäße Vorrichtung zur Erzeugung einer haptischen Rückmeldung der tastenlosen Eingabeeinheit gemäß Variante 3.
- Figur 6: Eine Draufsicht auf eine erfindungsgemäße Vorrichtung zur Erzeugung einer haptischen Rückmeldung der tastenlosen Eingabeeinheit gemäß Variante 4.
- Figur 7: Eine Draufsicht auf eine erfindungsgemäße Vorrichtung zur Erzeugung einer haptischen Rückmeldung der tastenlosen Eingabeeinheit gemäß Variante 5.
- Figur 8: Eine Draufsicht auf eine erfindungsgemäße Vorrichtung zur Erzeugung einer haptischen Rückmeldung der tastenlosen Eingabeeinheit gemäß Variante 6.

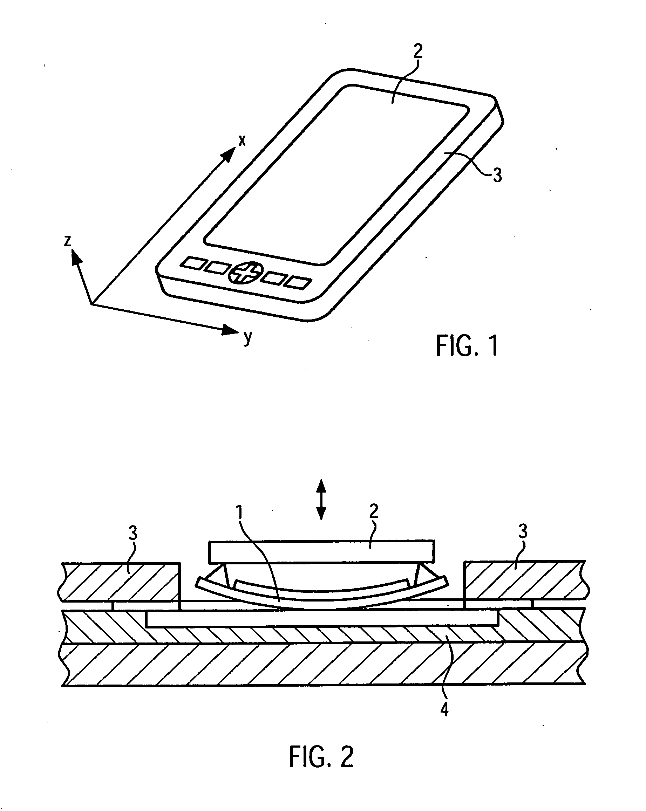

Figur 1 zeigt eine perspektivische Ansicht eines Eingabegerätes mit einer tastenlosen Eingabeeinheit 2. Das Eingabegerät ist als mobiles Eingabegerät (PDA) mit einer tastenlosen Eingabeeinheit 2 und einer erfindungsgemäßen Vorrichtung zur Erzeugung einer haptischen Rückmeldung der tastenlosen Eingabeeinheit 2 ausgestattet. Die Eingabeeinheit 2 umfasst einen sog. "Touchscreen".

Figur 2 zeigt eine schematisch dargestellte Schnittansicht des Eingabegerätes mit der tastenlosen Eingabeeinheit 2. Dargestellt sind ein vorderes Gehäuse 3 des Eingabegerätes, das Display der tastenlosen Eingabeeinheit 2, die erfindungsgemäße Vorrichtung 1 zur Erzeugung einer haptischen Rückmeldung der tastenlosen Eingabeeinheit 2 und eine unter der erfindungsgemäßen Vorrichtung 1 angeordnete Leiterplatte oder Platine 4, welche Träger von elektronischen Funktionseinheiten des Eingabegerätes ist und über welche die elektrische Ansteuerung der erfindungsgemäßen Vorrichtung 1, insbesondere der piezoelektrischen Elemente, erfolgt.
Das Gehäuse bildet eine Struktur des Eingabegerätes im Sinne der Erfindung. Solange die angestrebte Funktion der haptischen Rückmeldung der tastenlosen Eingabeeinheit 2 gewährleistet ist, kann die Vorrichtung 1 aber auch alternativ an anderen Teilen der Struktur des Eingabegerätes festgelegt werden, z.B. an der Leiterplatte oder Platine 4.

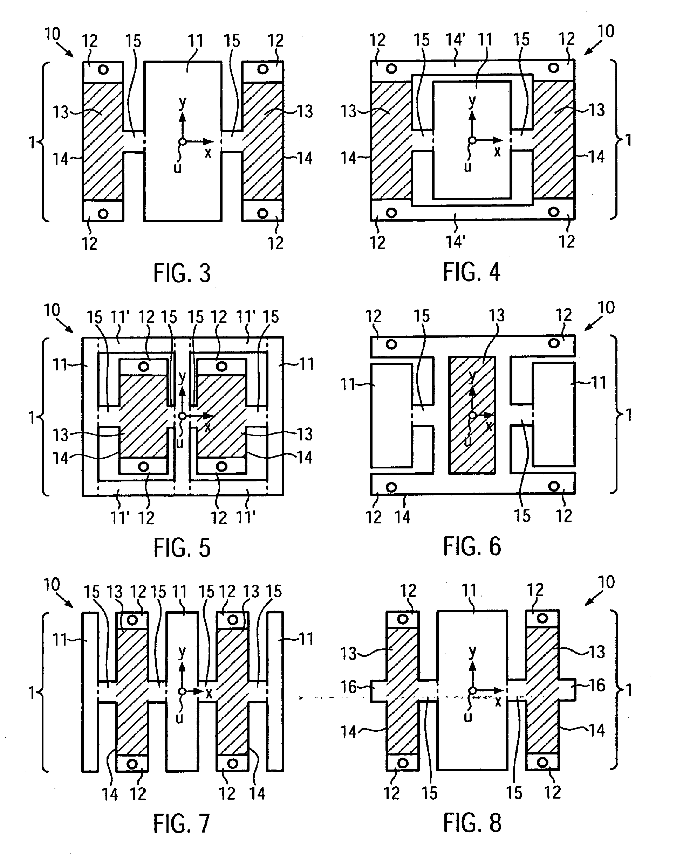

Figur 3 zeigt eine Draufsicht auf eine erfindungsgemäße Vorrichtung 1 zur Erzeugung einer haptischen Rückmeldung der tastenlosen Eingabeeinheit gemäß Variante 1. Die erfindungsgemäße Vorrichtung 1 zur Erzeugung der haptischen Rückmeldung der tastenlosen Eingabeeinheit gemäß Variante 1 umfasst ein elastisches und flexibles, im Wesentlichen plattenförmiges Substrat 10, das eine erste Lagerstelle 11 zur Festlegung des Substrats 10 an einer Struktur des Eingabegeräts und insgesamt vier zweite Lagerstellen 12 zur Festlegung des Substrats 10 an der Eingabeeinheit umfasst, und derart ausgebildet ist, um die Eingabeeinheit beweglich gegenüber der Struktur des Eingabegeräts zu lagern. Als erste Lagerstellen 11 werden die Abschnitte des Substrats 10 bezeichnet, die bei der Montage des Eingabegeräts mit einer Struktur des Eingabegeräts gekoppelt werden. Als zweite Lagerstellen 12 werden die Abschnitte des Substrats 10 bezeichnet, die bei der Montage des Eingabegeräts mit der Eingabeeinheit 2 gekoppelt werden. Das Substrat 10 ist einstückig aus Leiterkartenmaterial, Metall, Kunststoff oder Keramik gefertigt. Um die Kontaktierung der piezoelektrischen Elemente sicherzustellen, ist das Substrat 10 aus elektrisch leitfähigem Material gefertigt und/oder mit elektrisch leitfähigem Material beschichtet.

Die ersten und zweiten Lagerstellen 11, 12 befinden sich auf ersten und zweiten Lagerabschnitten 11, 14, die aus dem Substrat 10 freigeschnitten und über einen Steg 15 verbunden sind. Die rechteckigen und streifenförmigen Lagerabschnitte 11, 14 erstrecken sich parallel zueinander jeweils senkrecht zum Steg 15 und zu beiden Seiten des Stegs 15, wobei der erste Lagerabschnitt 11 zwischen zwei zweiten Lagerabschnitten 14 angeordnet ist. Im vorliegenden Fall wird der gesamte erste Lagerabschnitt 11 mit einer Struktur 3 eines Eingabegeräts gekoppelt und bildet demnach die erste Lagerstelle 11. Es können aber auch nur Teile des ersten Lagerabschnitts 11 mit einer Struktur 3 eines Eingabegeräts gekoppelt werden. Die insgesamt vier zweiten Lagerstellen 12 sind spiegelsymmetrisch zu den Achsen x, y, die sich in einem Mittelpunkt bzw. Ursprung U des Substrats 10 treffen, auf dem Substrat 10 an den freien Enden der zweiten Lagerabschnitte 14 angeordnet. In den Eckbereichen des Substrats 10 sind kreisförmige Öffnungen dargestellt, welche mittig der Lagerstellen 12 angeordnet sind und von Verbindungsmitteln durchsetzbar sind, um das Substrat 10 an die Eingabeeinheit anzukoppeln. Die ersten und zweiten Lagerabschnitte 11, 14 erstrecken sich parallel zur x-Achse und die Stege 15 zwischen den ersten und zweiten Lagerabschnitten 11, 14 erstrecken sich auf der bzw. parallel zur y-Achse.

Piezoelektrische Elemente 13 sind zwischen den ersten und zweiten Lagerstellen 11, 12 des Substrats 10 auf den zweiten Lagerabschnitten 14 derart angeordnet, dass bei einer elektrischen Ansteuerung der piezoelektrischen Elemente 13 die vier zweiten Lagerstellen 12 gegenüber der ersten Lagerstelle 11 bewegt werden, insbesondere senkrecht zur Ebene des plattenförmigen Substrats 10 aus der Ebene des plattenförmigen Substrats 10 heraus. Die piezoelektrischen Elemente 13 können auf einer Oberseite und/oder einer Unterseite des Substrats 10 angebracht oder in das Substrat 10 eingebettet sein.

Das Substrat 10 und die gesamte Vorrichtung 1 sind vorzugsweise spiegelsymmetrisch zu den Achsen x, y ausgebildet, um ein gleichmäßiges Anheben und Absenken einer angekoppelten Eingabeeinheit gegenüber einer angekoppelten Struktur eines Eingabegeräts gewährleisten zu können.

Figur 4 zeigt eine Draufsicht auf eine erfindungsgemäße Vorrichtung 1 zur Erzeugung einer haptischen Rückmeldung der tastenlosen Eingabeeinheit gemäß Variante 2. Abweichend von Variante 1 sind die zweiten Lagerabschnitte 14, die beidseitig des ersten Lagerabschnitts 11 angeordnet sind, über Stege 14' miteinander verbunden und bilden einen geschlossenen Rahmen, der den ersten Lagerabschnitt 11 vollumfänglich umgibt. Die ersten und zweiten Lagerabschnitte 11, 14 sind mittig über Stege 15 verbunden. Im Übrigen kann die Vorrichtung 1 dieselben Merkmale aufweisen, die im Zusammenhang mit Variante 1 erläutert wurden. Zudem werden dieselben Bezugszeichen verwendet, die im Zusammenhang mit Variante 1 erläutert wurden.

Figur 5 zeigt eine Draufsicht auf eine erfindungsgemäße Vorrichtung 1 zur Erzeugung einer haptischen Rückmeldung der tastenlosen Eingabeeinheit gemäß Variante 3. Abweichend von Variante 1 ist nicht nur ein erster Lagerabschnitt 11 zwischen den zweiten Lagerabschnitten 14 angeordnet, sondern zwei weitere erste Lagerabschnitte 11 sind außerhalb der zweiten Lagerabschnitte 14 angeordnet. Die ersten Lagerabschnitte 11 sind über Stege 11' zu einem geschlossenen Rahmen verbunden, der jeden der zweiten Lagerabschnitte 14 vollumfänglich umgibt. Die ersten und zweiten Lagerabschnitte 11, 14 sind mittig über Stege 15 verbunden. Im Übrigen kann die Vorrichtung 1 dieselben Merkmale aufweisen, die im Zusammenhang mit Variante 1 erläutert wurden. Zudem werden dieselben Bezugszeichen verwendet, die im Zusammenhang mit Variante 1 erläutert wurden.

Figur 6 zeigt eine Draufsicht auf eine erfindungsgemäße Vorrichtung 1 zur Erzeugung einer haptischen Rückmeldung der tastenlosen Eingabeeinheit gemäß Variante 4. Abweichend von Variante 1 ist ein zweiter Lagerabschnitt 12 zwischen zwei ersten Lagerabschnitten 11 angeordnet, wobei die Enden der zweiten Lagerabschnitte 14 im wesentlichen T-förmig ausgebildet sind, um einen offenen, im wesentlichen H-förmigen Rahmen zu bilden, der die ersten, im wesentlichen rechteckigen Lagerabschnitte 11 in den Aussparungen des H-Profils aufnimmt und an jeweils drei von vier Seiten umgibt. Die Lagerstellen 12 befinden sich an den freien Enden der T-Stücke. Die ersten und zweiten Lagerabschnitte 11, 14 sind mittig über Stege 15 verbunden. Im übrigen kann die Vorrichtung 1 dieselben Merkmale aufweisen, die im Zusammenhang mit Variante 1 erläutert wurden. Zudem werden dieselben Bezugszeichen verwendet, die im Zusammenhang mit Variante 1 erläutert wurden.

Figur 7 zeigt eine Draufsicht auf eine erfindungsgemäße Vorrichtung 1 zur Erzeugung einer haptischen Rückmeldung der tastenlosen Eingabeeinheit gemäß Variante 5. Abweichend von Variante 1 sind insgesamt drei parallele, rechteckige und streifenförmige erste Lagerabschnitte 11 zwischen und außerhalb von insgesamt zwei parallelen, rechteckigen und streifenförmigen zweiten Lagerabschnitten 12 angeordnet. Die Lagerstellen 12 befinden sich an den freien Enden der zweiten Lagerabschnitte 14. Die ersten und zweiten Lagerabschnitte 11, 14 sind mittig über Stege 15 verbunden. Im Übrigen kann die Vorrichtung 1 dieselben Merkmale aufweisen, die im Zusammenhang mit Variante 1 erläutert wurden. Zudem werden dieselben Bezugszeichen verwendet, die im Zusammenhang mit Variante 1 erläutert wurden.

Figur 8 zeigt eine Draufsicht auf eine erfindungsgemäße Vorrichtung zur Erzeugung einer haptischen Rückmeldung der tastenlosen Eingabeeinheit gemäß Variante 6. Abweichend von Variante 1 sind außerhalb der parallelen, streifenförmigen und rechteckigen zweiten Lagerabschnitten 12 stegartige Ansätze 16 vorgesehen. Im Übrigen kann die Vorrichtung 1 dieselben Merkmale aufweisen, die im Zusammenhang mit Variante 1 erläutert wurden. Zudem werden dieselben Bezugszeichen verwendet, die im Zusammenhang mit Variante 1 erläutert wurden.

In einem zweiten Ausführungsbeispiel der Erfindung ist die Vorrichtung als ein einzelner Biegeaktuator gemäß dem Aufbau eines piezoelektrischen Flächenwandlers ausgebildet, wobei das piezoelektrische Element in das Substrat eingebettet ist und die elektrische Kontaktierung über flexible und schwingfeste Zuleitungen realisiert wird. Das Substrat ist vorzugsweise wie im ersten Ausführungsbeispiel gestaltet. Alternativ kann der Aufbau der Vorrichtung auch dergestalt sein, dass ein handelsüblicher piezoelektrischer Flächenwandler, z.B. ,DuraAct', in einem passiven Substrat (beispielsweise einer Metallplatte) eingebettet ist. Solche handelsüblichen piezoelektrischen Flächenwandler haben die folgenden Hauptanwendungsgebiete: Lärmreduktion, Schwingungskontrolle, Konturverformung und Stabilisierung, Energieerzeugung (Energy Harvesting), hochdynamische und präzise Stellelemente und Schadensüberwachung (Health Monitoring). Als piezoelektrische Bauelemente überführen die Flächenwandler (auch Patch Wandler oder Patch Transducer genannt) elektrische Spannung in mechanische Energie und umgekehrt. Sie können sowohl als Biegewandler, präzise Stellglieder, hochdynamische Sensoren oder auch als Energieerzeuger eingesetzt werden. Grundlage ist eine dünne piezokeramische Folie, die mit elektrisch leitendem Material zur elektrischen Kontaktierung bedeckt und anschließend in einen duktilen Polymerverbundstoff eingebettet wird. Die an sich spröde Piezokeramik wird dadurch mechanisch vorgespannt und elektrisch isoliert und ist so robust, dass sie auf gekrümmten Oberflächen mit Biegeradien bis zu 20 mm aufgebracht werden kann.

Die erfindungsgemäße Vorrichtung 1 wird wie folgt realisiert:

Die Vorrichtung gemäß dem ersten Ausführungsbeispiel der Erfindung ist in den Figuren 3 bis 8 dargestellt und umfasst die Varianten 1-6. Grundgedanke ist es, die Vorrichtung 1 als einfach zu montierende Aktuatoreinheit auszubilden, die auf dem Prinzip des piezoelektrischen Biegewandlers basiert, eine einfache Halterung (festes Ende) ermöglicht und die mindestens zwei, besser aber vier frei bewegliche Enden der Teilbieger aufweist, die in ihrer geometrischen Ausgestaltung an die vier Ecken des Displays angekoppelt werden können. Das Grundprinzip ist in Figur 3 als Variante 1 dargestellt: Ein passives Substrat 10, das im wesentlichen in seinen Abmessungen denen des Displays entspricht, wird so ausgestaltet, dass es zwei in der Mitte gehalterte, streifenförmige zweite Lagerabschnitte 14 enthält. Auf diese zweiten Lagerabschnitte 14 wird jeweils eine piezoelektrische Platte 13 geklebt, so dass sich zwei in der Mitte gelagerte unimorphe Biegeelemente ergeben. Bei einer elektrischen Ansteuerung der piezoelektrischen Wandler 13 können sich die freien Enden der streifenförmigen zweiten Lagerabschnitte 14, an welchen die zweiten Lagerstellen angeordnet sind, relativ aus der Ebene des unverformten Substrates 10, insbesondere senkrecht zur Ebene des unverformten Substrates 10, bewegen.

Vorteilhafterweise ist das Substrat 10 zumindest auf einer Seite metallisiert, wodurch bereits beim Klebeprozess eine elektrische Kontaktierung der piezokeramischen Wandler 13 realisiert wird. Durch eine strukturierte Ausgestaltung der Substratmetallisierung kann die zweite Elektrode der piezokeramischen Wandler 13 durch eine kurze elektrische Verbindung mit der Metallisierung des Substrates 10 verbunden werden. Zur Erhöhung der Robustheit der Vorrichtung 1 kann aber auch die gesamte zweite Elektrodenfläche der piezoelektrischen Wandler 13 mit einer flexiblen und dehnungsresistenten Kontaktierung verklebt werden, die wiederum mit der Metallisierung des Substrates 10 verbunden wird.

Als Substratmaterial kommt vorzugsweise Leiterkartenmaterial wie FR-4-Substrat zum Einsatz. Grundsätzlich können aber auch andere Materialien wie Metalle, Kunststoffe, faserverstärkte Kunststoffe oder keramische Substrate verwendet werden.

Das piezoelektrische Element 13 ist vorzugsweise eine piezokeramische Platte oder eine Platte aus einkristallinem Material. Zudem kann das piezoelektrische Element einen Multilayeraufbau mit inneren, zwischen den Piezomaterialschichten angeordneten Elektroden (Innenelektroden), und äußeren, der Kontaktierung der Innenelektroden dienende Elektroden (Außenelektroden) aufweisen, wobei die Innenelektroden sowohl parallel, als auch senkrecht zu den Außenelektroden angeordnet sein können, um entsprechende Piezoeffekte (d₃₁ oder d₃₃) auszunutzen. Das piezoelektrische Element 13 kann aber auch ein piezoelektrischer Flächenwandler oder Patch sein.

Durch die geometrischen Abmessungen, insbesondere die Dicke des Substrates 10, die Breite der streifenförmigen ersten und zweiten Lagerabschnitte 11, 14 und der piezoelektrischen Wandler 13 sowie durch den E-Modul des Substrates 10 können die Auslenkungen an den freien Enden der Lagerabschnitte 11, 14 und die Blockierkraft in weiten Grenzen eingestellt werden. Durch einen experimentellen Versuchsaufbau konnte gezeigt werden, dass die geforderten Parameter bezüglich der Auslenkung und der Blockierkraft erreichbar sind. Viel wichtiger ist aber, dass eine haptische Signalisierung generiert werden konnte.

Die erfindungsgemäße Vorrichtung 1 bietet eine Mehrzahl von Signalisierungsmöglichkeiten. Eine steile Schaltflanke oder ein kurzer Impuls generiert eine sogenannte "click" Signalisierung, eine Burstansteuerung generiert eine Vibrationssignalisierung, die bei optimaler Dimensionierung auch eine zusätzliche Vorrichtung zur Erzeugung eines Vibrationsalarms ersetzen kann. Die aufgezeigten Varianten sind nur beispielhaft und es sind weitere Ausgestaltungen denkbar, die der jeweiligen Anwendung angepasst werden können. Die strukturierten Leiterbahnen auf dem Substrat 10 können mit weiteren Kontaktelementen ausgestaltet sein, die eine einfache elektrische Verbindung mit anderen elektronischen Einheiten des Gerätes ermöglichen.

Es ist aber auch vorstellbar, dass weitere elektronische Komponenten direkt auf dem Substrat 10 aufgebracht werden. Zur mechanischen Verbindung der erfindungsgemäßen Vorrichtung 1 mit der Eingabeeinheit (Display) 2 einerseits und der Struktur des Eingabegerätes (Gehäuse) andererseits können an den entsprechenden Lagerstellen 11, 12 des Substrates 10 einfach montierbare Verbindungselemente angebracht werden.

Die Vorrichtung gemäß dem zweiten Ausführungsbeispiel der Erfindung zielt darauf ab, die geforderte Funktionalität durch oder mit Hilfe eines strukturierten piezoelektrischen Flächenwandlers zu realisieren. Grundsätzlich kann ein piezoelektrischer Flächenwandler so aufgebaut werden, dass er eine integrierte Biegefunktion enthält. Dazu ist es erforderlich die piezokeramische Platte so in den Flächenwandler einzubetten, dass die Mittelebene der Platte nicht mit der Mittelebene des Flächenwandlers züsammenfällt. Alle mechanischen und elektrischen Kontaktierungselemente können in den Flächenwandler integriert werden. Ein solcher strukturierter Flächenwandler bietet gegenüber dem ersten Ausführungsbeispiel der Erfindung eine höhere Robustheit.

Die Erfindung hat die folgenden Vorteile:

Die vorgeschlagenen Lösungsansätze erfüllen die Anforderung für eine haptische (taktile) Rückmeldung, so dass das Display einer tastenlosen Eingabeeinheit als Ganzes im Wesentlichen senkrecht zur Gehäusefläche in mindestens einer Richtung bewegbar ist. Es können kostengünstige Materialien der Elektrotechnik verwendet werden. Die Substrate 10 können mit Standardverfahren der Leiterplattentechnik hergestellt werden. Sowohl für die elektrische Kontaktierung als auch für die mechanische Ankopplung können Standardlösungen der Leiterkartentechnik eingesetzt werden.

## Patentansprüche

1. Vorrichtung (1) zur Erzeugung einer haptischen Rückmeldung einer tastenlosen Eingabeeinheit (2) eines Eingabegerätes, wobei die Vorrichtung (1) ein elastisches, im Wesentlichen plattenförmiges Substrat (10) aufweist, **dadurch gekennzeichnet, dass** das mindestens eine erste Lagerstelle (11) zur Festlegung des Substrats (10) an einer Struktur (3) des Eingabegeräts und mindestens eine zweite Lagerstelle (12) zur Festlegung des Substrats (10) an der Eingabeeinheit (2) umfasst, und derart ausgebildet ist, um die Eingabeeinheit (2) beweglich gegenüber einer Struktur (3) des Eingabegeräts zu lagern, wobei ein piezoelektrisches Element (13) zwischen den ersten und zweiten Lagerstellen (11, 12) des Substrats (10) mit diesem derart verbunden ist, dass sich ein unimorphes Biegeelement ergibt und bei einer elektrischen Ansteuerung des piezoelektrischen Elements (13) eine der Lagerstellen (11, 12) quer zur Ebene des plattenförmigen Substrats (10) bewegt wird.

2. Vorrichtung (1) nach Anspruch 1, **dadurch gekennzeichnet, dass** das piezoelektrische Element (13) in das Substrat (10) eingebettet ist.

3. Vorrichtung (1) nach einem der vorangegangenen Ansprüche, **dadurch gekennzeichnet, dass** ein piezoelektrisches Element (13) auf einer Oberseite und/oder einer Unterseite des Substrats (10) angebracht ist.

4. Vorrichtung (1) nach einem der vorangegangenen Ansprüche, **dadurch gekennzeichnet, dass** mehrere zweite Lagerstellen (12) symmetrisch, vorzugsweise spiegelsymmetrisch, bevorzugt doppelt spiegelsymmetrisch, auf dem Substrat (10) angeordnet sind.

5. Vorrichtung (1) nach einem der vorangegangenen Ansprüche, **dadurch gekennzeichnet, dass** sich die ersten und zweiten Lagerstellen (11, 12) auf ersten und zweiten Lagerabschnitten (11, 14) befinden, die über einen Steg (15) verbunden sind.

6. Vorrichtung (1) nach Anspruch 5, **dadurch gekennzeichnet, dass** zumindest einer der Lagerabschnitte (11, 14), vorzugsweise die ersten und zweiten Lagerabschnitte (11, 14), aus dem Substrat (10) freigeschnitten ist/sind.

7. Vorrichtung (1) nach einem der vorangegangenen Ansprüche, **dadurch gekennzeichnet, dass** die Lagerabschnitte (11, 14) sich jeweils quer, vorzugsweise senkrecht, zum Steg (15), bevorzugt zu beiden Seiten des Stegs (15), erstrecken.

8. Vorrichtung (1) nach einem der vorangegangenen Ansprüche, **dadurch gekennzeichnet, dass** eine zweite Lagerstelle (12) an einem freien Ende eines zweiten Lagerabschnitts (14) angeordnet ist.

9. Vorrichtung (1) nach einem der vorangegangenen Ansprüche, **dadurch gekennzeichnet, dass** ein erster Lagerabschnitt (11) zwischen zwei zweiten Lagerabschnitten (14) angeordnet ist und/oder umgekehrt.

10. Vorrichtung (1) nach einem der vorangegangenen Ansprüche, **dadurch gekennzeichnet, dass** mindestens ein erster Lagerabschnitt (11) einen Rahmen bildet, der einen zweiten Lagerabschnitt (14) zumindest über die Hälfte seines Umfangs, vorzugsweise über seinen gesamten Umfang, umgibt und/oder umgekehrt.

11. Vorrichtung (1) nach einem der vorangegangenen Ansprüche, **dadurch gekennzeichnet, dass** das piezoelektrische Element (13) in und/oder auf einem zweiten Lagerabschnitt (14) angeordnet ist.

12. Vorrichtung (1) nach einem der vorangegangenen Ansprüche, **dadurch gekennzeichnet, dass** das Substrat (10) einstückig ausgebildet ist.

13. Vorrichtung (1) nach einem der vorangegangenen Ansprüche, **dadurch gekennzeichnet, dass** das Substrat (10) aus Leiterkartenmaterial, Metall, Kunststoff oder Keramik gefertigt ist.

14. Vorrichtung (1) nach einem der vorangegangenen Ansprüche, **dadurch gekennzeichnet, dass** das Substrat (10) aus elektrisch leitfähigem Material gefertigt und/oder mit elektrisch leitfähigem Material beschichtet ist.

15. Mobiles Eingabegerät mit einer tastenlosen Eingabeeinheit (2) und einer Vorrichtung (1) zur Erzeugung einer haptischen Rückmeldung der tastenlosen Eingabeeinheit (2) nach einem der vorangegangenen Ansprüche, wobei eine der ersten Lagerstellen (11) des Substrats (10) an einer Struktur (3) des Eingabegeräts festgelegt ist und eine der zweiten Lagerstellen (12) des Substrats (10) an der Eingabeeinheit (2) festgelegt ist.

## Claims

1. Device (1) for the production of a haptic feedback from a keyless input unit (2) of an input device, wherein the device (1) has an elastic, essentially plate-shaped substrate (10), **characterized in that** which at least comprises a first support location (11) for fixing the substrate (10) on a structure (3) of the input device and at least a second support location (12) for fixing the substrate (10) on the input unit (2), and is formed to support the input unit (2) movably with respect to the structure (3) of the input device, wherein a piezoelectric element (13) between the first and second support locations (11, 12) of the substrate (10) is connected to it such that a unimorphous bending element results and with an electrical drive to the piezoelectric element (13) one of the support locations (11, 12) is moved transverse to the plane of the plate-shaped substrate (10).

2. Device (1) according to Claim 1, **characterized in that** the piezoelectric element (13) is embedded in the substrate (10).

3. Device (1) according to one of the preceding claims, **characterized in that** a piezoelectric element (13) is fitted to an upper side and / or an underside of the substrate (10).

4. Device (1) according to one of the preceding claims, **characterized in that** several second support locations (12) are arranged symmetrically, preferably mirrored, preferably doubly mirrored, on the substrate (10).

5. Device (1) according to one of the preceding claims, **characterized in that** the first and second support locations (11, 12) are located on the first and second support sections (11, 14), which are connected via a ridge (15).

6. Device (1) according to one of the preceding claims, **characterized in that** at least one of the support sections (11, 14), preferably the first and second support sections (11, 14) is / are cut free from the substrate (10).

7. Device (1) according to one of the preceding claims, **characterized in that** the support sections (11, 14) extend in each case laterally, preferably perpendicular, to the ridge (15), preferably on both sides of the ridge (15).

8. Device (1) according to one of the preceding claims, **characterized in that** a second support location (12) is arranged on one free end of a second support section (14).

9. Device (1) according to one of the preceding claims, **characterized in that** a first support section (11) is arranged between two second support sections (14) and / or vice versa.

10. Device (1) according to one of the preceding claims, **characterized in that** at least one first support section (11) forms a frame surrounding a second support section (14) at least over half of its circumference, preferably over its complete circumference and / or vice versa.

11. Device (1) according to one of the preceding claims, **characterized in that** the piezoelectric element (13) is arranged in and / or on a second support section (14).

12. Device (1) according to one of the preceding claims, **characterized in that** the substrate (10) is formed in one piece.

13. Device (1) according to one of the preceding claims, **characterized in that** the substrate (10) is produced from printed circuit board material, metal, plastic or ceramics.

14. Device (1) according to one of the preceding claims, **characterized in that** the substrate (10) is produced from electrically conducting material and / or coated with electrically conducting material.

15. Mobile input device with a keyless input unit (2) and a mechanism (1) for production of a haptic feedback from the keyless input unit (2) according to one of the preceding claims, wherein one of the first support locations (11) of the substrate (10) is fixed on a structure (3) of the input device and one of the second support locations (12) of the substrate (10) is fixed on the input unit (2).

## Revendications

1. Dispositif (1) pour produire un message de réponse haptique d'une unité de saisie (2) sans touches d'un appareil de saisie, le dispositif (1) présentant un substrat (10) élastique, sensiblement en forme de plaque, **caractérisé en ce qu'**il comprend au moins une première zone de support d'appui (11) pour fixer le substrat (10) à une structure (3) de l'appareil de saisie, et au moins une deuxième zone de support d'appui (12) pour fixer le substrat (10) à l'unité de saisie (2), et est conçu pour monter l'unité de saisie (2) de manière mobile par rapport à une structure (3) de l'appareil de saisie, un élément piézoélectrique (13) entre les premières et deuxièmes zones de support d'appui (11, 12) du substrat (10) étant relié à ce dernier de manière telle, qu'il en résulte un élément de flexion unimorphe et que, lors d'une commande électrique de l'élément piézoélectrique (13), une des zones de support d'appui (11, 12) soit déplacée transversalement au plan du substrat (10) en forme de plaque.

2. Dispositif (1) selon la revendication 1, **caractérisé en ce que** l'élément piézoélectrique (13) est encastré dans le substrat (10).

3. Dispositif (1) selon l'une des revendications précédentes, **caractérisé en ce qu'**un élément piézoélectrique (13) est appliqué sur un côté supérieur et/ou un côté inférieur du substrat (10).

4. Dispositif (1) selon l'une des revendications précédentes, **caractérisé en ce que** plusieurs deuxièmes zones de support d'appui (12) sont agencées sur le substrat (10), de manière symétrique, de préférence selon une symétrie par réflexion, et plus particulièrement une symétrie par réflexion double.

5. Dispositif (1) selon l'une des revendications précédentes, **caractérisé en ce que** les premières et deuxièmes zones de support d'appui (11, 12) se trouvent sur des premiers et deuxièmes tronçons de support d'appui (11, 14), qui sont reliés par l'intermédiaire d'une nervure (15).

6. Dispositif (1) selon la revendication 5, **caractérisé en ce qu'**au moins un des tronçons de support d'appui (11, 14), de préférence les premiers et deuxièmes tronçons de support d'appui (11, 14) est/sont dégagés du substrat (10) par découpage de celui-ci.

7. Dispositif (1) selon l'une des revendications précédentes, **caractérisé en ce que** les tronçons de support d'appui (11, 14) s'étendent respectivement transversalement, de préférence perpendiculairement à la nervure (15), et de préférence des deux côtés de la nervure (15).

8. Dispositif (1) selon l'une des revendications précédentes, **caractérisé en ce qu'**une deuxième zone de support d'appui (12) est agencée à une extrémité libre d'un deuxième tronçon de support d'appui (14).

9. Dispositif (1) selon l'une des revendications précédentes, **caractérisé en ce qu'**un premier tronçon de support d'appui (11) est agencé entre deux deuxièmes tronçons de support d'appui (14) et/ou inversement.

10. Dispositif (1) selon l'une des revendications précédentes, **caractérisé en ce qu'**au moins un premier tronçon de support d'appui (11) forme un cadre, qui entoure un deuxième tronçon de support d'appui (14) au moins sur la moitié de sa périphérie, de préférence sur la totalité de sa périphérie, et/ou inversement.

11. Dispositif (1) selon l'une des revendications précédentes, **caractérisé en ce que** l'élément piézoélectrique (13) est agencé dans et/ou sur un deuxième tronçon de support d'appui (14).

12. Dispositif (1) selon l'une des revendications précédentes, **caractérisé en ce que** le substrat (10) est réalisé d'un seul tenant.

13. Dispositif (1) selon l'une des revendications précédentes, **caractérisé en ce que** le substrat (10) est fabriqué en un matériau de carte de circuit imprimé, en métal, en matière plastique ou en céramique.

14. Dispositif (1) selon l'une des revendications précédentes, **caractérisé en ce que** le substrat (10) est fabriqué en un matériau électriquement conducteur et/ou est revêtu d'un matériau électriquement conducteur.

15. Appareil de saisie mobile comprenant une unité de saisie (2) sans touches et un dispositif (1) pour produire un message de réponse haptique de l'unité de saisie (2), selon l'une des revendications précédentes, l'une des premières zones de support d'appui (11) du substrat (10) étant fixée à une structure (3) de l'appareil de saisie, et l'une des deuxièmes zones de support d'appui (12) du substrat (10) étant fixée à l'unité de saisie (2).
